# EUROPÄISCHE PATENTSCHRIFT

(11) **EP 3 192 180 B1**
(45) Veröffentlichungstag und Bekanntmachung des Hinweises auf die Patenterteilung: **21.06.2023**
(21) Anmeldenummer: 15741537.3
(22) Anmeldetag: 22.07.2015
(51) Int. Cl.: H04B 1/00, H03J 1/00

(54) **HF-FILTERMODUL MIT VERBESSERTER ERWEITERBARKEIT**
HF FILTER MODULE WITH IMPROVED EXPANDABILITY
MODULE DE FILTRAGE HF À CAPACITÉ D'EXTENSION AMÉLIORÉE

(30) Priorität: 10.09.2014 DE 102014113052
(43) Veröffentlichungstag der Anmeldung: 19.07.2017
(73) Patentinhaber: SnapTrack, Inc., San Diego, CA 92121 (US)
(72) Erfinder: SCHMIDHAMMER, Edgar, 83371 Stein an der Traun (DE); METZGER, Thomas, 81379 München (DE)
(74) Vertreter: Bardehle Pagenberg Partnerschaft mbB Patentanwälte Rechtsanwälte
(86) Internationale Anmeldenummer: PCT/EP2015/066775
(87) Internationale Veröffentlichungsnummer: WO 2016/037752

(56) Entgegenhaltungen:
- DE-A1- 10 053 205
- US-A1- 2013 250 819
- US-B1- 6 584 304

## Beschreibung

Die Erfindung betrifft HF-Module, z. B. Filtermodule für mobile Kommunikationsgeräte, die auf einfache Weise um eine Vielzahl an Filtern für weiter abzudeckende Frequenzbänder erweitert werden können.

HF-Module können in Mobilfunkgeräten Verwendung finden und z. B. HF-Filter eines Frontends umfassen. Solche Module und ihre enthaltenen HF-Filter sind dafür zuständig, dass in einem Mobilfunkgerät die HF-Signale mit den richtigen Frequenzen an die entsprechenden Empfangsverstärker und HF-Signale mit den richtigen Frequenzen von einem Leistungsverstärker an eine Antenne übermittelt werden können, ohne sich gegenseitig zu stören. Problematisch ist, dass moderne Kommunikationsgeräte dazu vorgesehen sein sollen, eine immer größer werdende Anzahl an Frequenzbändern bzw. Übertragungssystemen bearbeiten zu können. Insbesondere die so genannte "Carrier Aggregation", also die Kombination verschiedener Frequenzbänder für einen erweiterten Bandbreitebedarf, bringt übliche HF-Module an ihre Grenzen.

Es ist möglich, im Signalpfad eines Frontend-Moduls eine Vielzahl an HF-Filtern mit Vielfachschaltern zu verbinden, um entsprechenden Signalen die zugehörigen Signalwege über die passenden HF-Filter zuzuweisen. Solche Vielfachschalter haben eine Vielzahl von Schalterpositionen, was zum einen die Signalqualität verschlechtert und zum anderen die Erweiterbarkeit erschwert. Denn soll ein HF-Modul weitere Frequenzbänder oder verschiedene Frequenzbänder gleichzeitig übertragen können, ist der Vielfachschalter im Allgemeinen durch einen erweiterten, neu zu entwerfenden Vielfachschalter mit noch höherem internen Schaltungsaufwand zu ersetzen.

Ferner birgt die Erweiterung eines HF-Moduls die Problematik, zusätzliche Schaltungskomponenten in einem Bauelement unterzubringen, ohne dass sich verschiedene Schaltungskomponenten gegenseitig stören.

Druckschrift DE 100 53 205 A1 schlägt eine kombinierte Frontentschaltung für ein Kommunikationsendgerät vor, welches für einen Multiband- und/oder Multimode-Betrieb ausgelegt ist. Es werden verschiedene Ausführungen angegeben, die für Mobilfunkgeräte der Dritten Generation und insbesondere für Übertragungssysteme nach dem UMTS-Standard unter Einbeziehung eines Multiband-GSM-Systems geeignet sind.

Druckschrift US 2013/250819 A1 offenbart eine Hochfrequenz (RF)-Frontendschaltung mit einem Notch-Diplexer. Der Notch-Diplexer umfasst ein Hochpassfilter, das zwischen einem Hochband-Port und einem Antennenport gekoppelt ist, und ein Tiefpass-Notchfilter, das zwischen einem Tiefband-Port und dem Antennenport gekoppelt ist. Das Hochpassfilter ist dazu ausgebildet, ein Hochband-Empfangssignal mit einer Hochband-Trägerfrequenz am Antennenport zu empfangen und das Hochband-Empfangssignal an den Hochband-Port weiterzuleiten. Das Tiefpass-Sperrfilter ist so ausgebildet, dass es ein Tiefband-Sendesignal mit einer Tiefband-Trägerfrequenz am Tiefband-Port empfängt und die Verzerrung im Tiefband-Sendesignal um ein Sperrstoppband abschwächt, bevor das Tiefband-Sendesignal zum Antennenport geleitet wird. Gemäß einer Ausführungsform umfasst das Notch-Stop-Band die Trägerfrequenz für das hohe Band.

Druckschrift US 6584304 B1 offenbart eine schaltbare Breitbandempfängereingangsstufe für einen Mehrbandempfänger, umfassend ein Rundsendesignalempfangsmittel zum Empfangen von Rundsendesignalen innerhalb mehrerer Empfangsfrequenzbänder, einen an das Rundsendesignalempfangsmittel angeschlossenen rauscharmen Breitbandverstärker zum Verstärken der rundgesendeten Signale aller Empfangsfrequenzbänder und zum Ausgeben eines verstärkten Ausgangssignals, das zu mehreren Schaltern eines Schaltmittels verzweigt wird, wobei die Anzahl der Schalter der Anzahl von Empfangsfrequenzbändern entspricht. Die schaltbare Breitbandempfängereingangsstufe umfasst weiterhin mehrere Filter, die jeweils an einen der Schalter angeschlossen sind, wobei jedes Filter eine Bandpaßfilterungskennlinie aufweist zum Durchlassen aller Signale innerhalb eines assoziierten Empfangsfrequenzbands.

Es ist deshalb eine Aufgabe der vorliegenden Erfindung, ein Modul anzugeben, das leichter an einen steigenden Bandbreitebedarf anzupassen ist, eine höhere Bauteildichte ohne großen zusätzlichen Designaufwand ermöglicht und eine verbesserte Signalqualität erlaubt. Das Modul soll ferner eine Duplexer-Funktionalität erlauben können, wobei die Isolation zwischen den einzelnen (Duplexer-)Filtern bzw. zwischen den zugehörigen Schaltern erhöht ist.

Ferner ist es eine Aufgabe der vorliegenden Erfindung, passende Verwendungen für ein solches Modul anzugeben. Diese Aufgaben werden durch die Gegenstände der unabhängigen Ansprüche gelöst. Abhängige Ansprüche geben vorteilhafte Ausgestaltungen an.

Ein HF-Modul umfasst dazu zwei Filtereinheiten. Jede der beiden Filtereinheiten enthält dabei ein erstes HF-Filter mit einem Eingang und einem Ausgang sowie einen ersten Schalter mit zwei möglichen Schaltzuständen. In jeder Filtereinheit ist der erste Schalter mit dem Eingang oder dem Ausgang des ersten HF-Filters verschaltet. Die beiden Filtereinheiten selbst sind parallel zueinander verschaltet.

Der erste Schalter und das erste Filter können in jeder Filtereinheit in Serie verschaltet sein. In einem der beiden möglichen Schaltzustände ist der Eingang des ersten Schalters mit demjenigen Ausgang des ersten Schalters elektrisch leitend verbunden, der in Serie mit dem HF-Filter verschaltet ist. Im zugehörigen zweiten möglichen Schalterzustand kann der Eingang des ersten Schalters vom ersten HF-Filter entkoppelt sein.

Die erleichterte Erweiterbarkeit des HF-Moduls wird dadurch erhalten, dass pro abzudeckendem Frequenzband eine Filtereinheit vorgesehen wird. Dabei kann jedes erste HF-Filter der entsprechenden Filtereinheit über den ersten Schalter im Modul aktiviert, aber auch deaktiviert werden. Die Notwendigkeit von Vielfachschaltern entfällt. Die Aufgabe eines Vielfachschalters wird an eine Vielzahl an Zweifachschaltern übertragen, wobei im Regelfall nur eine geringe Anzahl an Zweifachschaltern, z. B. eins oder zwei, einen Signalfluss über ein HF-Filter erlaubt, sodass der gesamte Schaltungsaufwand der aktiven Schalter reduziert und die Signalqualität verbessert ist. Die Erhöhung des Schaltungsaufwands durch eine höhere Anzahl an Zweifachschaltern wird durch die Verringerung des Schaltungsaufwands pro Schalter mehr als kompensiert.

Alle ersten Schalter aller Filtereinheiten können dabei mit einer gemeinsamen Signalschiene verbunden sein. Alle Signalausgänge der ersten Filter können mit einer weiteren Signalschiene verbunden oder über weitere Schalter mit einer solchen Schiene koppelbar sein. Der Schaltungsaufwand des gesamten HF-Moduls steigt somit nur noch linear mit der Zahl der abzudeckenden HF-Filter. Jede Filtereinheit mit ihrem Schalter und ihrem HF-Filter kann so realisiert sein, dass ein Zusammenfügen einer Vielzahl von Filtereinheiten, z. B. gestapelt oder nebeneinander angeordnet, problemlos und quasi ohne HF-Leiterbahnüberkreuzungen möglich ist.

Durch die Kombination aus Filter und Schalter in einer Filtereinheit kann eine höhere Bauteildichte realisiert werden, da aufgrund einer möglichen 3D-Integration, bei der Schaltungskomponenten übereinandergestapelt sind oder Filtereinheiten übereinandergestapelt sind, die entsprechenden Einheiten weniger Flächenbedarf aufweisen. Durch die deutlich vereinfachte Signalführung ist die Signalqualität verbessert und die Isolation, z. B. im Falle eines Duplexers, erhöht. Die einzelnen Filter verschiedener Filtereinheiten können physikalisch voneinander getrennt angeordnet sein. Die Realisierung der verschiedenen vereinfachten Schalter kann auf einem gemeinsamen Chip erfolgen. Dann ist es möglich, die Signalqualität dadurch zu verbessern, dass die verschiedenen Schalter galvanisch nicht auf dem Chip, sondern extern verbunden sind.

Für zumindest eine Filtereinheit gilt das Folgende: Die Filtereinheit umfasst einen zweiten Schalter, der wiederum zwei mögliche Schaltzustände hat. Der erste Schalter ist mit dem Eingang des HF-Filters verschaltet und der zweite Schalter ist mit dem Ausgang des HF-Filters verschaltet. Das erste HF-Filter ist somit zwischen dem ersten Schalter und dem zweiten Schalter verschaltet. Sind die ersten Schalter mit einer ersten Signalschiene und die zweiten Schalter mit einer zweiten Signalschiene verkoppelt, so können die ersten HF-Filter individuell mit gar keiner, nur mit der ersten, nur mit der zweiten oder mit beiden Signalschienen verbunden werden.

Zusätzlich weist zumindest eine Filtereinheit ein zweites Filter mit einem Eingang und einem Ausgang auf. Das zweite Filter ist parallel zum ersten Filter geschaltet. Die Filtereinheit realisiert einen Duplexer, wobei ein gemeinsamer Ausgang des Duplexers über den zweiten Schalter geführt wird. Das erste Filter und das zweite Filter der entsprechenden Filtereinheit können dabei insbesondere bezüglich ihrer Mittenfrequenzen und (im Falle eines Bandpassfilters) ihrer Bandbreiten so realisiert sein, dass die entsprechende Filtereinheit einen Duplexer realisiert.

Somit ist pro Filtereinheit eine Duplexer-Funktionalität möglich. Durch das Vorsehen weiterer Filter und weiterer Zweifachschalter können pro Filtereinheit aber auch Quadplexer oder Hexaplexer vorgesehen sein.

Zusätzlich weist die Filtereinheit einen dritten Schalter mit zwei möglichen Schaltzuständen auf. Der dritte Schalter ist mit dem Eingang des zweiten Filters verschaltet.

Stellen die beiden Filter die Filter eines Duplexers dar, so ist es möglich, dass der erste Schalter mit einem Signalpfad, ausgewählt aus Sendesignalpfad und Empfangssignalpfad des Duplexers, verschaltet ist. Der dritte Schalter ist dann entsprechend mit dem jeweils anderen der beiden oben aufgeführten Signalpfade verschaltet. Der zweite Schalter ist mit dem gemeinsamen Signalpfad, z. B. einem Antennensignalpfad, verschaltet.

Zusätzlich ist es möglich, dass in zumindest einer Filtereinheit jeder Schalter drei Anschlüsse hat. Jeder Schalter hat dabei einen ersten Anschluss, über den er mit einem HF-Filter der Filtereinheit verschaltet ist. Zusätzlich ist es möglich, dass jeder Schalter mit dem zweiten der drei Anschlüsse mit einer Abschlussimpedanz verschaltet ist.

Über die Abschlussimpedanz kann eine Impedanzanpassung erfolgen. So ist es z. B. möglich, eine Terminierung über einen geeigneten Impedanzwert gegen Masse vorzusehen, um beispielsweise unerwünschte Reflexionen auszuschließen.

Zusätzlich ist es möglich, dass in zumindest einer Filtereinheit jeder Schalter mit seinem dritten von drei Anschlüssen mit einer Signalschiene verschaltet ist. Dabei kann der erste Schalter über seinen dritten Anschluss mit einer ersten Signalschiene und der zweite Schalter über seinen dritten Anschluss mit einer zweiten Signalschiene verschaltet sein.

Damit ist es möglich, HF-Signale zwischen der ersten Signalschiene und der zweiten Signalschiene über ein optimal angepasstes HF-Filter, das durch entsprechende Schalterposition der Filtereinheiten ausgewählt ist, auszutauschen.

Zusätzlich ist es möglich, dass zumindest eine Filtereinheit eine Steuerschaltung aufweist, mittels derer die Schaltzustände der Schalter der Filtereinheit steuerbar sind. Die Steuerschaltung decodiert dabei ein Steuersignal, das von einer externen Schaltungsumgebung empfangen werden kann, und erzeugt die entsprechenden an die einzelnen Schalter gerichteten Schaltsignale.

Zusätzlich ist es möglich, dass der dritte Anschluss des ersten Schalters einer Filtereinheit mit einem Sendeverstärker verschaltet ist.

Der Sendeverstärker kann dabei ein konventioneller Leistungsverstärker, z. B. ein Multi-Mode-Multi-Band-Leistungsverstärker (MMMB-PA), sein.

Zusätzlich ist es möglich, dass der dritte Anschluss des zweiten Schalters einer Filtereinheit mit einem Antennenanschluss verschaltet ist.

Der Antennenanschluss kann dabei mit einer Antenne eines Kommunikationsgeräts verbunden sein.

Zusätzlich ist es möglich, dass der dritte Anschluss des dritten Schalters einer Filtereinheit mit einem Empfangsverstärker verschaltet ist.

Der Empfangsverstärker kann beispielsweise ein konventioneller rauscharmer Verstärker sein.

Insbesondere ist es möglich, dass alle dritten Anschlüsse der ersten Schalter aller Filtereinheiten mit einem Sendeverstärker verschaltet sind. Ferner ist es möglich, dass alle dritten Anschlüsse der zweiten Schalter aller Filtereinheiten mit einem Antennenanschluss verschaltet sind.

Ebenso ist es möglich, dass alle dritten Anschlüsse der dritten Schalter aller Filtereinheiten mit einem Empfangsverstärker verschaltet sind.

Die Verschaltung der dritten Anschlüsse des ersten Schalters aller Filtereinheiten kann dabei über eine erste Signalschiene realisiert sein. Die Verschaltung der dritten Anschlüsse der zweiten Schalter aller Filtereinheiten kann über eine gemeinsame zweite Signalschiene realisiert sein. Die Verschaltung aller dritten Anschlüsse der dritten Schalter aller Filtereinheiten kann über eine gemeinsame dritte Signalschiene erfolgen.

Die Zahl der Filtereinheiten ist dabei nicht auf zwei beschränkt. Das HF-Modul kann eine oder mehrere weitere Filtereinheiten umfassen. Insbesondere kann die Zahl der Filtereinheiten auch fünf, sechs, sieben, acht, neun oder zehn betragen.

Zusätzlich ist es möglich, dass alle Filtereinheiten die gleiche Schaltungstopologie aufweisen. Die HF-Filter der Filtereinheiten können jeweils Bandpassfilter sein und sich jeweils durch ihre Bandbreiten und/oder Mittenfrequenzen unterscheiden.

Dabei ist es bevorzugt, dass HF-Filter derselben Filtereinheit direkt benachbarte Durchlassbänder aufweisen.

Ein oben beschriebenes HF-Modul kann beispielsweise in einem Mobilfunkgerät, z. B. in einem Mobiltelefon, oder in einer Mobilfunkanlage, z. B. in einem Kraftfahrzeug, verwendet werden. Auch die Verwendung in sogenannten SMART-Cells oder in sogenannten Pico-Cells ist möglich. Auch die Verwendung in WLAN-Routern oder WLAN-Endbenutzergeräten oder z. B. in Gegenständen des "Internet of Things" wie Gegenstände des täglichen und bewussten oder unbewussten Gebrauchs ist möglich.

Das HF-Modul, sein Aufbau und seine Funktionsweise werden nachfolgend anhand von schematischen Figuren näher erläutert.

Es zeigen:
- Fig. 1:: den prinzipiellen Aufbau des Moduls,
- Fig. 2:: die Benennung der Ein- bzw. Ausgänge der Schaltungskomponenten einer Filtereinheit,
- Fig. 3:: den schematischen Aufbau einer Filtereinheit mit zwei Schaltern und einem HF-Filter,
- Fig. 4:: den schematischen Aufbau einer Filtereinheit mit drei Schaltern und zwei HF-Filtern,
- Fig. 5:: eine zusammenfassende Übersicht über ein Modul mit einer Filtereinheit mit einer Steuerschaltung,
- Fig. 6:: eine mögliche Verschaltung von Abschlussimpedanzen innerhalb einer Filtereinheit,
- Fig. 7:: eine Übersichtsdarstellung eines Moduls mit einer Filtereinheit mit einem HF-Filter, zwei Schaltern und einer Steuerschaltung,
- Fig. 8:: eine Übersichtsdarstellung eines Moduls mit einer Filtereinheit mit zwei HF-Filtern, drei Schaltern und einer Steuerschaltung,
- Fig. 9:: das Schema der leichten Erweiterbarkeit durch Hinzufügen weiterer Filtereinheiten, um zusätzliche Frequenzbänder abdecken zu können, wobei Filtereinheiten über eine gemeinsame Signalschiene mit einem Verstärker verschaltet sind,
- Fig. 10:: die leichte Erweiterbarkeit, bei der alle Filtereinheiten über eine gemeinsame Signalschiene mit einem rauscharmen Verstärker verschaltet sind,
- Fig. 11:: die leichte Erweiterbarkeit im Falle von Filtereinheiten, die als Duplexer ausgestaltet sind,
- Fig. 12:: eine mögliche physikalische Realisierung durch gestapelte Filtereinheiten,
- Fig. 13:: eine alternative mögliche Realisierung durch nebeneinander angeordnete Filtereinheiten.

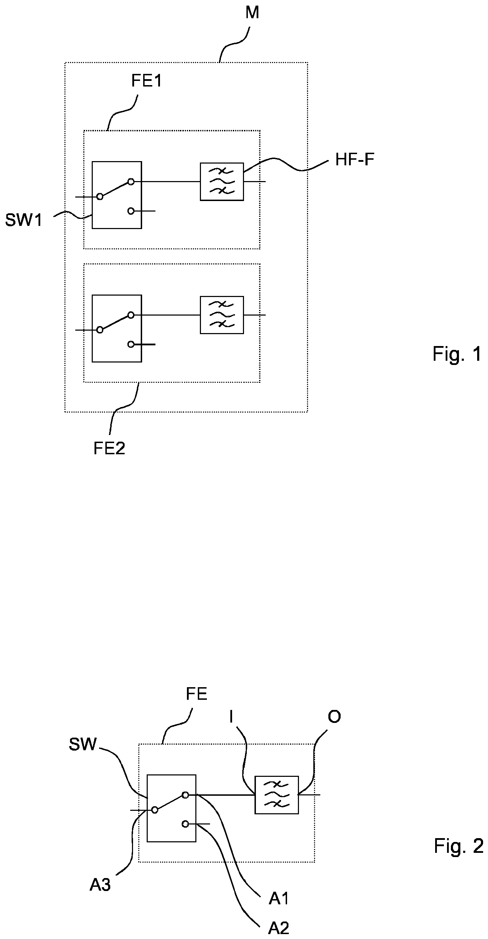

Figur 1 zeigt das grundsätzliche Schema, nach dem ein HF-Modul M mit seinen Filtereinheiten FE1, FE2 realisiert ist. Innerhalb des Moduls M sind die erste Filtereinheit FE1 und die zweite Filtereinheit FE2 parallel geschaltet. Jede der beiden Filtereinheiten hat einen ersten Schalter SW1 und ein erstes HF-Filter HF-F. Die beiden ersten Schalter haben einen Signaleingang und erlauben zwei mögliche Schaltzustände. In jeweils einem der beiden Schaltzustände ist der Signaleingang des jeweiligen ersten Schalters mit dem entsprechenden (ersten) HF-Filter HF-F verschaltet.

Durch Hinzufügen identischer oder ähnlicher Filtereinheiten kann das Modul ohne großen Aufwand und insbesondere ohne große Änderung der grundsätzlichen Schaltungstopologie an eine Vielzahl von Frequenzbändern angepasst werden. Insbesondere falls die Carrier-Aggregation Verwendung finden soll, kann über die Schalterstellung der ersten Schalter eine Kombination unterschiedlicher HF-Filter aktiviert werden. Der Schaltungsaufwand ist deswegen im Vergleich zu konventionellen HF-Modulen verringert, da lediglich Zweifachschalter benötigt werden. Der komplexe Schaltungsaufwand von Vielfachschaltern entfällt.

Figur 2 illustriert die Bezeichnung unterschiedlicher Anschlüsse: Das HF-Filter ist über einen Eingang I mit dem Schalter SW, nämlich über dessen ersten Anschluss A1, verbunden. Der dritte Anschluss A3 des Schalters SW realisiert einen Signaleingang der Filtereinheit FE. Über einen zweiten Anschluss A2 des Schalters SW kann der Schalter SW mit einer Abschlussimpedanz verbunden sein.

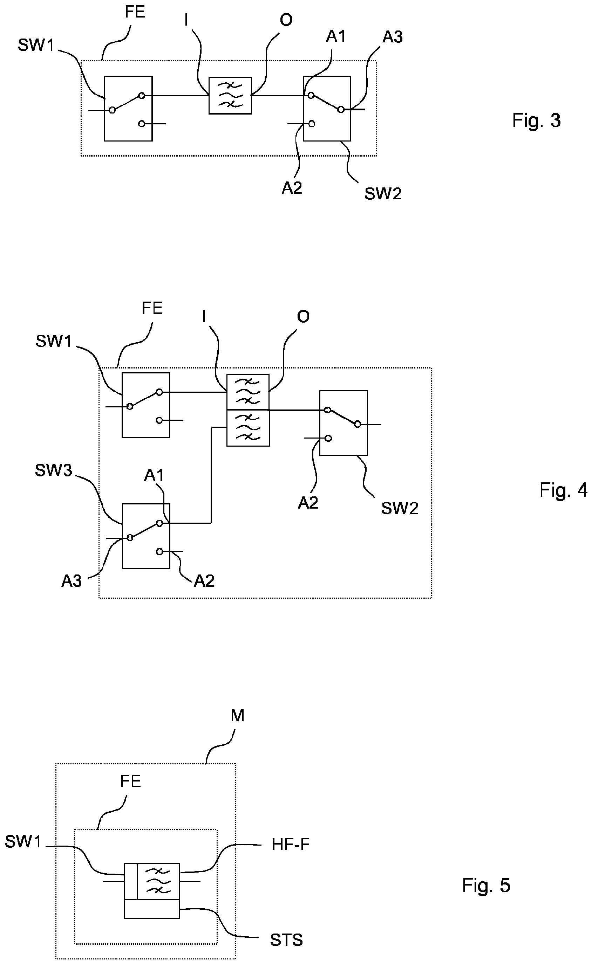

Figur 3 illustriert die Benennungen der Anschlüsse des zweiten Schalters SW2: Über den ersten Anschluss A1 des zweiten Schalters SW2 ist der zweite Schalter SW2 mit dem HF-Filter verschaltet. Über den dritten Anschluss A3 des zweiten Schalters SW2 kann die Filtereinheit FE mit deren Ausgang verbunden sein. Über den zweiten Anschluss A2 des zweiten Schalters SW2 kann der Schalter mit einer Abschlussimpedanz verschaltet sein.

Die Signalrichtung der in den Figuren 2 und 3 gezeigten Schalter und Filter kann auch umgekehrt sein, sodass ein Signal vom zweiten Schalter SW2 über das Filter zum ersten Schalter SW1 geleitet werden kann.

Figur 4 illustriert die Bezeichnung der Anschlüsse des dritten Schalters. So ist der erste Anschluss A1 des dritten Schalters SW3 mit dem zweiten Filter verschaltet. Über den dritten Anschluss A3 des dritten Schalters SW3 kann die Filtereinheit FE mit einer zur Verschaltung mit dem dritten Schalter SW3 vorgesehenen Signalschiene verschaltet sein.

Über den zweiten Anschluss A2 kann der dritte Schalter SW3 über eine Abschlussimpedanz mit Masse verschaltet sein.

Für alle drei Schalter SW1, SW2, SW3 einer Filtereinheit FE gilt somit, dass der erste Anschluss jeweils zur Verschaltung mit einem Filter vorgesehen ist. Die zweiten Anschlüsse A2 können zur Verschaltung mit einer Abschlussimpedanz vorgesehen sein. Die dritten Anschlüsse können zur Verschaltung mit einer von drei möglichen Signalschienen vorgesehen sein.

Figur 5 zeigt eine Ausführungsform, bei der das HF-Modul M eine Filtereinheit FE umfasst, bei der die Schalterstellung des ersten Schalters SW1 durch eine Steuerschaltung STS gesteuert wird.

Die Steuerschaltung STS kann dabei Steuersignale einer externen Schaltungsumgebung empfangen und in entsprechende Aktions-Signale für den Schalter SW1 umsetzen.

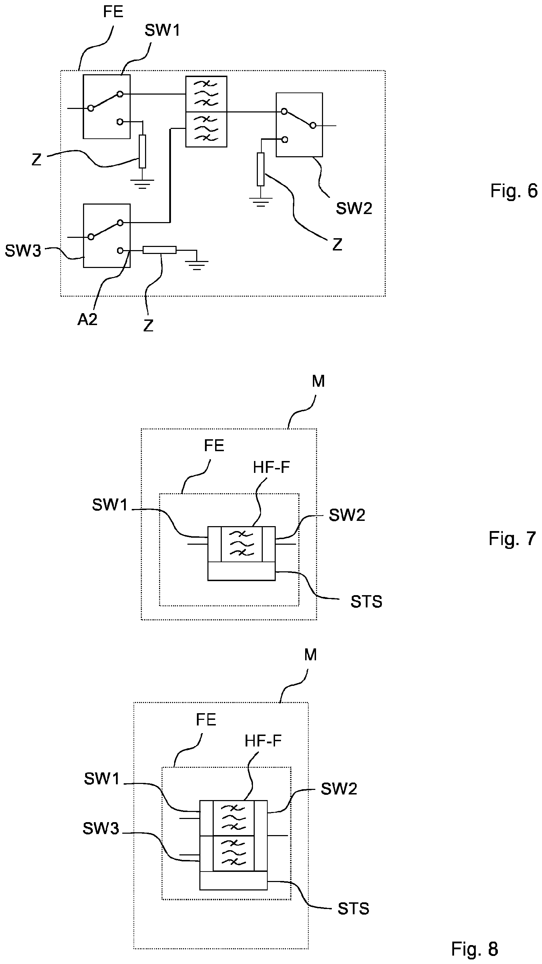

Figur 6 zeigt eine Ausführungsform einer Filtereinheit FE mit drei Schaltern, zwei HF-Filtern und drei Abschlussimpedanzen 2. Jeweils der zweite Anschluss A2 der drei Schalter SW1, SW2, SW3 ist über eine Abschlussimpedanz 2 mit Masse verschaltet.

Figur 7 zeigt eine Ausführungsform einer Filtereinheit FE in einem HF-Modul M, bei der eine Steuerschaltung STS die Schaltungszustände der beiden Schalter SW1, SW2 steuert.

Figur 8 zeigt eine Ausführungsform einer Filtereinheit FE eines HF-Moduls M, bei der eine Steuerschaltung STS die Schaltungszustände aller drei Schalter SW1, SW2, SW3 steuert. Die beiden HF-Filter HF können dabei die zwei Filter eines Duplexers darstellen, sodass lediglich drei Schalter notwendig sind, da der gemeinsame Ausgang des Duplexers über den zweiten Schalter SW2 geführt wird.

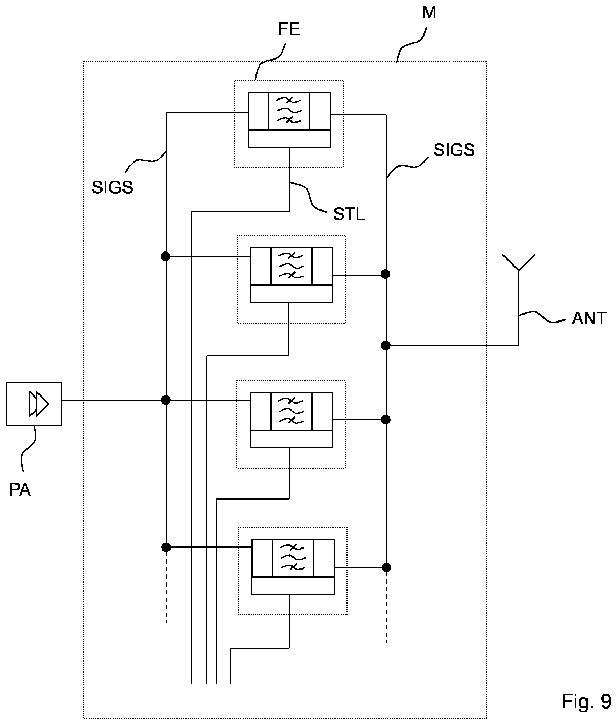

Figur 9 zeigt, wie das Modul durch Hinzufügen zusätzlicher Filtereinheiten FE erweitert werden kann. Es gibt eine eingangsseitige Signalschiene SIGS, die im konkreten Beispiel mit einem Leistungsverstärker PA verschaltet ist. Es gibt eine zweite Signalschiene SIGS, die mit einer Antenne verschaltet ist. Über die jeweiligen Schalter der Filtereinheiten, die über eine entsprechende Steuerleitung STL angesprochen werden können, kann jedes der Filter der Filtereinheiten individuell aktiviert werden, um geeignete Signalpfade für HF-Signale vom Verstärker zur Antenne zu öffnen. Da jeweils nur Zweifachschalter notwendig sind und die Komplexität von Vielfachschaltern entfällt, ist die Signalqualität verbessert. Bei einer notwendigen Erweiterung entfällt auch die Neukonstruktion des entsprechenden Vielfachschalters, über den einzelne Filter mit dem Verstärker verschaltet werden. Der Verstärker PA kann dabei ein MMMB-PA sein.

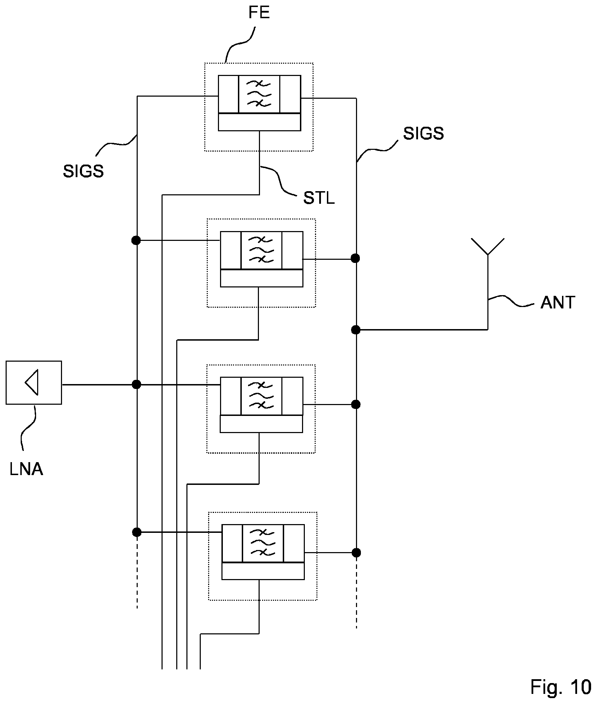

Figur 10 zeigt eine der Figur 9 analoge Situation für Empfangssignale.

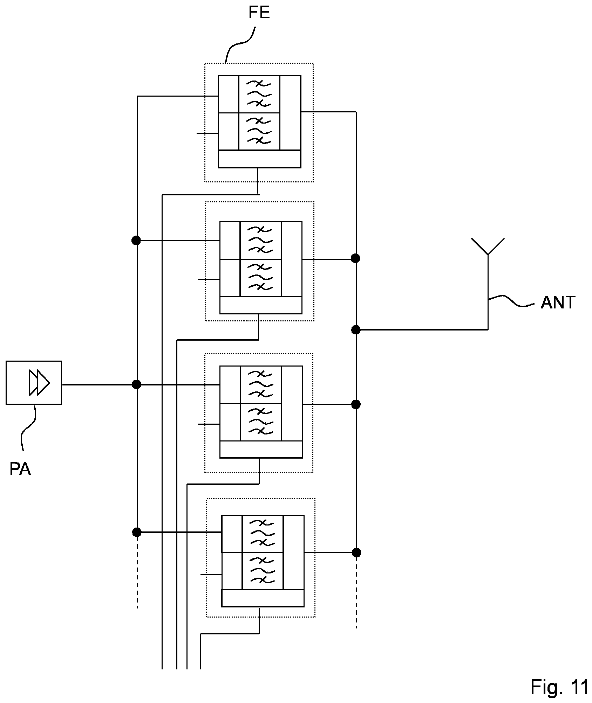

Figur 11 zeigt eine den Figuren 9 und 10 analoge Situation, bei der jede Filtereinheit FE zwei Filter eines Duplexers und drei Zweifachschalter umfasst, wobei die Schaltzustände der drei Schalter von einer Steuerschaltung gesteuert werden.

Eine Signalschiene ist mit einem Verstärker PA verbunden. Eine Signalschiene ist mit einer Antenne verbunden. Eine weitere Signalschiene (der Übersichtlichkeit halber nicht gezeigt) wäre mit den entsprechenden Empfangsfiltern der Duplexer einerseits und mit einem Empfangsverstärker andererseits verschaltet.

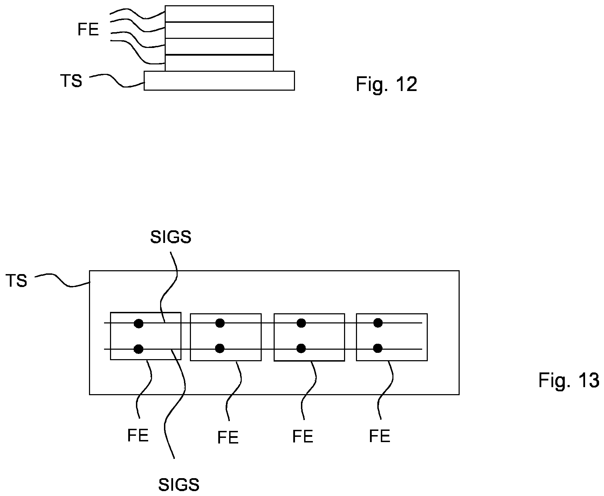

Figur 12 illustriert, wie verschiedene Filtereinheiten der gleichen Topologie auf einem Trägersubstrat TS übereinander gestapelt werden können, um mittels 3D-Integration bei geringstem Flächenbedarf ein kompaktes Bauelement zu ergeben. Zwei oder gegebenenfalls drei gemeinsam verwendete Signalschienen können durch Vias, die durch alle Filtereinheiten FE geführt sind, realisiert sein.

Figur 13 zeigt eine alternative Möglichkeit der Integration der Filtereinheiten FE auf einem Trägersubstrat TS. Dabei sind die unterschiedlichen Filtereinheiten FE nebeneinander auf dem Trägersubstrat TS angeordnet und z. B. über Durchkontaktierungen mit zwei oder gegebenenfalls drei Signalschienen SIGS verschaltet, die an der Oberseite oder in Metallisierungslagen innerhalb eines mehrlagigen Trägersubstrats TS angeordnet sein können.

Das HF-Modul ist dabei nicht auf die oben beschriebenen oder in den Figuren gezeigten Ausführungsbeispiele, die lediglich beispielhaften Charakter haben, beschränkt. Module, die zusätzliche Filtereinheiten aufweisen, oder Filtereinheiten, die zusätzliche Filter und/oder Schalter aufweisen, stellen ebenso mögliche Ausführungsformen dar.

### Bezugszeichenliste

- A1:: erster Schalteranschluss
- A2:: zweiter Schalteranschluss
- A3:: dritter Schalteranschluss
- ANT:: Antenne
- FE, FE1, FE2:: Filtereinheit
- HF-F:: HF-Filter
- I:: Filtereingang
- LNA:: rauscharmer Verstärker
- M:: HF-Modul
- O:: Filterausgang
- PA:: Leistungsverstärker
- SIGS:: Signalschiene
- STS:: Steuerschaltung
- SW, SW1, SW2, SW3:: Schalter
- TS:: Trägersubstrat
- Z:: Abschlussimpedanz

## Patentansprüche

1. HF-Modul (M), umfassend zwei Filtereinheiten (FE), von denen jede
- ein erstes HF-Filter (HF-F) mit einem Eingang (I) und einem Ausgang (O),
- einen ersten Schalter (SW1) mit zwei möglichen Schaltzuständen umfasst, wobei
- in jeder Filtereinheit (FE) der erste Schalter (SW1) mit dem Eingang (I) des ersten HF-Filters (HF-F) verschaltet ist und
- die beiden Filtereinheiten (FE) parallel verschaltet sind;
wobei für zumindest eine Filtereinheit (FE) gilt:
- die Filtereinheit (FE) umfasst einen zweiten Schalter (SW2) mit zwei möglichen Schaltzuständen,
- der erste Schalter (SW1) ist mit dem Eingang (I) verschaltet,
- der zweite Schalter (SW2) ist mit dem Ausgang (O) verschaltet,
- die Filtereinheit (FE) umfasst ein zweites Filter (HF-F) mit einem Eingang (E) und einem Ausgang (O),
- das zweite Filter (HF-F) ist parallel zum ersten Filter (HF-F) geschaltet,
- die Filtereinheit (FE) realisiert einen Duplexer, wobei ein gemeinsamer Ausgang des Duplexers über den zweiten Schalter (SW2) geführt wird,
- die Filtereinheit (FE) hat einen dritten Schalter (SW3) mit zwei möglichen Schaltzuständen,
- der dritte Schalter (SW3) ist mit dem Eingang (I) des zweiten Filters (HF-F) verschaltet.

2. HF-Modul nach Anspruch 1, wobei für zumindest eine Filtereinheit (FE) gilt:
- jeder Schalter (SW) hat drei Anschlüsse (A1, A2, A3),
- jeder Schalter (SW) ist mit einem ersten Anschluss (A1) mit einem HF-Filter (HF-F) der Filtereinheit (FE) verschaltet.

3. HF-Modul nach dem vorherigen Anspruch, wobei für zumindest eine Filtereinheit (FE) gilt:
- jeder Schalter (SW) ist mit einem zweiten Anschluss (A2) mit einer Abschlussimpedanz (Z) verschaltet.

4. HF-Modul nach einem der Ansprüche 2 oder 3, wobei für zumindest eine Filtereinheit (FE) gilt:
- jeder Schalter (SW) ist mit einem dritten Anschluss (A3) mit einer Signalschiene (SIGS) verschaltet.

5. HF-Modul nach einem der vorherigen Ansprüche, wobei für zumindest eine Filtereinheit (FE) gilt:
- die Filtereinheit (FE) hat eine Steuerschaltung (STS), um die Schalterzustände der Schalter (SW) zu steuern.

6. HF-Modul nach einem der vorherigen Ansprüche, wobei für zumindest eine Filtereinheit (FE) gilt:
- der dritte Anschluss (A3) des ersten Schalters (SW1) ist mit einem Sendeverstärker (PA) verschaltet.

7. HF-Modul nach einem der vorherigen Ansprüche, wobei für zumindest eine Filtereinheit (FE) gilt:
- der dritte Anschluss (A3) des zweiten Schalters (SW2) ist mit einem Antennenanschluss (ANT) verschaltet.

8. HF-Modul nach einem der vorherigen Ansprüche, wobei für zumindest eine Filtereinheit (FE) gilt:
- der dritte Anschluss (A3) des dritten Schalters (SW3) ist mit einem Empfangsverstärker (LNA) verschaltet.

9. HF-Modul nach einem der vorherigen Ansprüche, ferner umfassend eine oder mehr Filtereinheiten (FE).

10. HF-Modul nach einem der vorherigen Ansprüche, wobei
- alle Filtereinheiten (FE) eine gleiche Schaltungstopologie aufweisen,
- die HF-Filter (HF-F) der Filtereinheiten (FE) Bandpassfilter sind und
- die Bandpassfilter der Filtereinheiten (FE) unterschiedliche Bandbreiten und/oder Mittenfrequenzen aufweisen.

11. Mobilfunkgerät oder Mobilfunkanlage umfassend ein HF-Modul nach einem der Ansprüche 1 bis 10.

12. Verwendung eines HF-Moduls gemäß einem der Ansprüche 1 bis 10 in einem Mobilfunkgerät oder in einer Mobilfunkanlage.

## Claims

1. An HF module (M) comprising two filter units (FE), of which each comprises
- a first HF filter (HF-F) with an input (I) and an output (o),
- a first switch (SW1) with two possible switching states,
wherein
- in each filter unit (FE), the first switch (SW1) is connected to the input (I) of the first HF filter (HF-F), and
- the two filter units (FE) are connected in parallel;
wherein to at least one filter unit (FE), the following applies:
- the filter unit (FE) comprises a second switch (SW2) with two possible switching states,
- the first switch (SW1) is connected to the input (I),
- the second switch (SW2) is connected to the output (o),
- the filter unit (FE) comprises a second filter (HF-F) with an input (I) and an output (o),
- the second filter (HF-F) is connected in parallel to the first filter (HF-F),
- the filter unit (FE) implements a duplexer, wherein a common output of the duplexer is routed via the second switch (SW2),
- the filter unit (FE) comprises a third switch (SW3) with two possible switching states,
- the third switch (SW3) is connected to the input (I) of the second filter (HF-F).

2. The HF module according to claim 1, wherein to at least one filter unit (FE), the following applies:
- each switch (SW) has three connectors (Al, A2, A3),
- each switch (SW) is connected with a first connector (A1) to an HF filter (HF-F) of the filter unit (FE).

3. The HF module according to the preceding claim, wherein to at least one filter unit (FE), the following applies:
- each switch (SW) is connected with a second connector (A2) to a terminating impedance (Z).

4. The HF module according to one of claims 2 or 3, wherein to at least one filter unit (FE), the following applies:
- each switch (SW) is connected with a third connector (A3) to a signal bus (SIGS).

5. The HF module according to one of the preceding claims, wherein to at least one filter unit (FE), the following applies:
- the filter unit (FE) comprises a control circuit (STS) in order to control the switching states of the switches (SW).

6. The HF module according to one of the preceding claims, wherein to at least one filter unit (FE), the following applies:
- the third connector (A3) of the first switch (SW1) is connected to a transmission amplifier (PA).

7. The HF module according to one of the preceding claims, wherein to at least one filter unit (FE), the following applies:
- the third connector (A3) of the second switch (SW2) is connected to an antenna connector (ANT).

8. The HF module according to one of the preceding claims, wherein to at least one filter unit (FE), the following applies:
- the third connector (A3) of the third switch (SW3) is connected to a receiving amplifier (LNA).

9. The HF module according to one of the preceding claims, furthermore comprising one or more filter units (FE).

10. The HF module according to one of the preceding claims, wherein all filter units (FE) have a same circuit topology,
- the HF filters (HF-F) of the filter units (FE) are band-pass filters, and
- the band-pass filters of the filter units (FE) comprise different bandwidths and/or center frequencies.

11. Mobile radio device or mobile radio unit comprising an HF module according to one of claims 1 to 10.

12. Use of an HF module according to one of claims 1 to 10 in a mobile radio device or in a mobile radio unit.

## Revendications

1. Module HF (M), comprenant deux unités de filtrage (FE) dont chacune comprend
- un premier filtre HF (HF-F) avec une entrée (I) et une sortie (O),
- un premier commutateur (SW1) avec deux états de commutation possibles, dans lequel
- dans chaque unité de filtrage (FE) le premier commutateur (SW1) est connecté à l'entrée (I) du premier filtre HF (HF-F), et
- les deux unités de filtrage (FE) sont connectées en parallèle ;
- dans lequel, pour au moins une unité de filtrage (FE) :
- l'unité de filtrage (FE) comprend un deuxième commutateur (SW2) avec deux états de commutation possibles,
- le premier commutateur (SW1) est connecté à l'entrée (I),
- le deuxième commutateur (SW2) est connecté à la sortie (O),
- l'unité de filtrage (FE) comprend un deuxième filtre (HF-F) avec une entrée (E) et une sortie (O),
- le deuxième filtre (HF-F) est connecté en parallèle au premier filtre (HF-F),
- l'unité de filtrage (FE) réalise un duplexeur, une sortie commune du duplexeur étant dirigée par l'intermédiaire du deuxième commutateur (SW2),
- l'unité de filtrage (FE) possède un troisième commutateur (SW3) avec deux états de commutation possibles,
- le troisième commutateur (SW3) est connecté à l'entrée (I) du deuxième filtre (HF-F).

2. Module HF selon la revendication 1 dans lequel, pour au moins une unité de filtrage (FE) :
- chaque commutateur (SW) possède trois bornes (A1, A2, A3),
- chaque commutateur (SW) est connecté par une première borne (A1) à un filtre HF (HF-F) de l'unité de filtrage (FE) .

3. Module HF selon la revendication précédente dans lequel, pour au moins une unité de filtrage (FE) :
- chaque commutateur (SW) est connecté par une deuxième borne (A2) à une impédance de terminaison (Z).

4. Module HF selon l'une des revendications 2 ou 3 dans lequel, pour au moins une unité de filtrage (FE) :
- chaque commutateur (SW) est connecté par une troisième borne (A3) à un bus de signal (SIGS).

5. Module HF selon l'une des revendications précédentes dans lequel, pour au moins une unité de filtrage (FE) :
- l'unité de filtrage (FE) possède un circuit de commande (STS) pour commander les états de commutateur des commutateurs (SW).

6. Module HF selon l'une des revendications précédentes dans lequel, pour au moins une unité de filtrage (FE) :
- la troisième borne (A3) du premier commutateur (SW1) est connectée à un amplificateur d'émission (PA).

7. Module HF selon l'une des revendications précédentes dans lequel, pour au moins une unité de filtrage (FE) :
- la troisième borne (A3) du deuxième commutateur (SW2) est connectée à une borne d'antenne (ANT).

8. Module HF selon l'une des revendications précédentes dans lequel, pour au moins une unité de filtrage (FE) :
- la troisième borne (A3) du troisième commutateur (SW3) est connectée à un amplificateur de réception (LNA).

9. Module HF selon l'une des revendications précédentes, comprenant en outre une ou plusieurs unités de filtrage (FE).

10. Module HF selon l'une des revendications précédentes dans lequel
- toutes les unités de filtrage (FE) ont une topologie de circuit identique,
- les filtres HF (HF-F) des unités de filtrage (FE) sont des filtres passe-bande, et
- les filtres passe-bande des unités de filtrage (FE) ont des largeurs de bande et/ou des fréquences centrales différentes.

11. Appareil de téléphonie mobile ou installation de téléphonie mobile comprenant un module HF selon l'une des revendications 1 à 10.

12. Utilisation d'un module HF selon l'une des revendications 1 à 10 dans un appareil de téléphonie mobile ou dans une installation de téléphonie mobile.
